# EUROPEAN PATENT APPLICATION

(11) **EP 4 345 918 A1**
(43) Date of publication of application: **03.04.2024**
(21) Application number: 22207291.0
(22) Date of filing: 14.11.2022
(51) Int. Cl.: H01L 31/105, H01L 31/0232, H01L 31/028, H01L 31/0352, H01L 31/18, G02B 6/12

(54) **PHOTODETECTOR AND METHOD FOR FABRICATING A PHOTODETECTOR**

(30) Priority: 30.09.2022 EP 22199268
(71) Applicant: IHP GmbH - Innovations for High Performance Microelectronics / Leibniz-Institut für innovative Mikroelektronik, 15236 Frankfurt (Oder) (DE)
(72) Inventor: Lischke, Stefan, 15236 Frankfurt (Oder) (DE); Steckler, Daniel, 15236 Frankfurt (Oder) (DE); Goetz, Florian, 15236 Frankfurt (Oder) (DE)
(74) Representative: Eisenführ Speiser

(57) **Abstract**

The invention relates to a photodetector for detecting electromagnetic radiation. The photodetector comprises a lateral photodiode and a SiN waveguide. The lateral photodiode comprises an in-situ p-doped contact region (112), an in-situ n-doped contact region (114) and, sandwiched between the p-doped contact region and n-doped contact region along a lateral stacking direction (109), an intrinsically doped light-sensitive region (108). The SiN waveguide (102) comprises SiN and is configured to guide electromagnetic radiation along a propagation direction (104), the SiN waveguide being arranged on top of the lateral photodiode along a vertical stacking direction (107) that is perpendicular to the lateral stacking direction (109). At least a part of the light-sensitive region and at least a part of the SiN waveguide form a common upper interface (116) at which the light-sensitive region is in direct contact with the SiN waveguide. Moreover, the light-sensitive region (108) has a lateral width (110) along the lateral stacking direction of 300 nm or less.

## Description

### TECHNICAL FIELD

The present invention relates to a photodetector for detecting electromagnetic radiation, Moreover, the present invention relates to a photonic integrated circuit or an electronic photonic circuit comprising the photodetector. The invention also relates to a method for fabricating a photodetector and to a use of a photodetector for detection of electromagnetic radiation in the wavelength range of 0.8 µm to 1.65 µm.

### BACKGROUND OF THE INVENTION

Optical and optoelectronic components produced with a silicon-based technology are key components, for example, for optical telecommunications or for optical connections within or between microelectronics circuits. Examples of such components are couplers, waveguides, modulators and photodetectors, in particular.

Modern photodetectors use, for example, germanium (Ge) as a detector material due to its significantly better absorbance compared to silicon (Si) in the wavelength range used for optical communication (e.g., λ= 1.3 - 1.6 µm). A so-called PIN diode is often used as a detector. "P" stands for a p-doped region, "I" for an intrinsic region and "N" for an n-doped semiconductor region. Important parameters of the diode are dark-current, photocurrent, responsivity and opto-electrical bandwidth.

Germanium photodiodes with an opto-electrical bandwidth of 50 GHz and more have already been demonstrated. Such germanium photodiodes are typically produced by epitaxial growth of a germanium layer directly on an SOI (silicon-on-insulator) substrate or directly on bulk Si, which allows direct coupling of the detector to the waveguide, e.g., made from the monocrystalline Si layer of the SOI structure. The light to be detected can thus be supplied parallel to the waveguide-diode interface, which allows the diode to be independently optimized, to a degree, with regard to responsivity and opto-electrical bandwidth.

Such a germanium photodiode is described, e.g., by S. Lischke, et al. in "Silicon nitride waveguide coupled 67+ GHz Ge photodiode for non-SOl PIC and ePIC platforms," 2019 IEEE International Electron Devices Meeting (IEDM), 2019, pp. 33.2.1-33.2.4, doi: 10.1109/IEDM19573.2019.8993651. The Ge photodiode is directly coupled to a silicon nitride waveguide, showing more than 67 GHz bandwidth.

Recent improvements of germanium photodiode have been reported by S. Lischke, *et al.* and generally include in-situ doping of p-doped and n-doped Si regions of a lateral photodiode comprising an intrinsically doped Ge fin. For example, S. Lischke, et al. demonstrate in the article "Ultra-fast germanium photodiode with 3-dB bandwidth of 265 GHz", Nat. Photon. 15, 925-931 (2021), waveguide-coupled germanium photodiodes with opto-electrical 3-dB bandwidths of 265 GHz and 240 GHz at a photocurrent of 1 mA.

Correspondingly, WO 2022/043513 A1 discloses a diode comprising a p-doped region, an n-doped region, and a light-sensitive intrinsic region sandwiched laterally between the p-doped region and the n-doped region in a direction transverse to a direction of light propagation in the diode. The p-doped region is made of a first material doped with a first type of dopant and the n-doped region is made of a third material doped with a second type of dopant. The first material includes silicon or silicon germanium, the third material includes silicon or silicon germanium. The intrinsic region is made of a second material different to at least one of the first material and the third material, the second material including germanium, germanium tin, or silicon germanium. The intrinsic region has a maximal lateral extension between two lateral ends of the intrinsic region of equal to or below 400 nm. The p-doped region and the n-doped region are in-situ doped such that the intrinsic region is not doped when the diode is produced.

Yet, it is still desirable to provide further improved photodetectors based on germanium photodiodes with high bandwidths. In particular, it is still desired to provide fabrication schemes for making improved photodetectors based on germanium photodiodes available for commercial applications.

### SUMMARY OF THE INVENTION

The present invention is based on the objective of providing an improved photodetector for detecting electromagnetic radiation. The present invention includes the further objective of providing an improved method for fabricating a photodetector.

According to the invention, a photodetector for detecting electromagnetic radiation is proposed. The photodetector comprises a lateral photodiode and a SiN waveguide. The lateral photodiode comprises an in-situ p-doped contact region, an in-situ n-doped contact region and, sandwiched between the p-doped contact region and n-doped contact region along a lateral stacking direction, an intrinsically doped light-sensitive region. The SiN waveguide comprises SiN and is configured to guide electromagnetic radiation along a propagation direction. The SiN waveguide is arranged on top of the lateral photodiode along a vertical stacking direction that is perpendicular to the lateral stacking direction. In the photodetector, at least a part of the light-sensitive region and at least a part of the SiN waveguide form a common upper interface at which the light-sensitive region is in direct contact with the SiN waveguide. Moreover, the light-sensitive region has a lateral width along the lateral stacking direction of 300 nm or less, preferably, of 200 nm or less, e.g., of 150 nm or less.

The invention includes the recognition that SiN waveguides typically outperform SOI based waveguides in various aspects. For example, they offer an enhanced optical bandwidth, allowing for low loss waveguides in the classic communication bands, e.g., C- and O-bands, widely addressed by SOI based photonics, as well as in the visible wavelength range were Si waveguides have already become opaque. Moreover, due to the absence of two-photon absorption in SiN, the optical power handling is in general superior compared to Si waveguides. It is therefore advantageous to include SiN waveguides in photodetectors comprising a photodiode offering opto-electrical -3 dB bandwidth of 200 GHz or beyond by means of a light-sensitive region that has a lateral width 300 nm or less. Moreover, to achieve high coupling efficiency from SiN waveguide to the light-sensitive region a direct contact between the light-sensitive region and the SiN waveguide is advantageous.

Yet, with known device concepts, it is at least difficult if not impossible to realise the combination of a lateral photodiode with a SiN waveguide in a photodetector offering opto-electrical -3 dB bandwidth of 200 GHz or beyond for several reasons. For example, in some known device concepts as described, e.g., in WO 2022/043513 A1, a Ge fin can be realized by double patterning, and contact regions can be realized by in-situ doped Si regions. On the one hand, due to the in-situ doping, ion-implantation can entirely be waived such that unintended doping into the Ge region can be prevented which is beneficial for the photodetector performance, e.g., since a minority carrier diffusion can be efficiently suppressed. However, this approach is rather limited to the integration with SiN waveguides.

In particular, an inherent feature of this approach are protruding Si regions on top of the Ge region that are defining the actual height of the photodetector. These vertical Si offshoots additionally cause parasitic capacitances. Furthermore, for direct coupling to a SiN waveguide, which has to be positioned on top of the photodiode, these protruding Si offshoots prevent direct contact between the SiN-waveguide and the Ge region. Thinning could be performed to some extend but still there has to be some material left on top of the photodiode to not top damage the photodiode. Moreover, deposition of a SiN layer after the fabrication of the photodiode would leave rather thick SiN spacers aside the vertical Si region, which means that the silicide is kept at a certain distance. This would be on the expanse of the resistance, e.g., lower fRC.

Another important reason, which makes the integration of a SiN waveguide at least difficult if not impossible with known device concepts, e.g., of WO 2022/043513 A1, is that the SiN layer should be applied at comparatively high temperatures at about 700 °C, e.g., with low pressure chemical vapour deposition (LPCVD) to provide a low loss SiN waveguide also operating in the C-band wavelength region with high efficiency. Yet, applying a SiN layer for fabricating the SiN waveguide after having fabricated the photodiode using LPCVD would cause damage to the photodiode due to the high temperatures involved and lead to a significant degradation of the photodiode performance.

With the photodetector according to the invention, it is possible to combine a low loss SiN waveguide with a lateral photodiode that can be operated at an opto-electrical -3 dB bandwidth of 100 GHz or beyond, e.g., of 200 GHz or more. This is possible since the deposition of a SiN layer for fabricating the SiN waveguide can be carried out before fabricating the in-situ p-doped and n-doped contact regions. The deposition of the SiN layer is thus not limited by thermal budget constraints, as it would be the case in known device concepts. This has the advantage that dopant diffusion and deactivation effects provoked by thermal processes that both have negative effects on the opto-electrical bandwidth of the photodetector can be reduced or even prevented. Therefore, a photodetector including a SiN waveguide with improved opto-electrical bandwidth can be realised. In particular, patterning of the SiN layer to fabricate the SiN waveguide can be performed after fabrication of the photodiode while applying the SiN layer can be carried before fabrication of the photodiode. Thereby, it is possible to realise a direct contact between the light-sensitive region and the SiN waveguide, i.e., there is no gap between these two, which may result in an improved coupling efficiency from SiN waveguide to the light sensitive region.

Another advantage of the photodetector according to the invention is that parasitic capacitance can be prevented that would originate by vertically protruding offshoots made of the n-doped and p-doped material of the photodiode. Thereby, the RC time constant of the photodetector can be reduced in comparison to known device concepts resulting in turn in an improved opto-electrical bandwidth of the photodiode.

As the light-sensitive region serves to provide an optically active region, e.g., for detecting photons by the photoelectric effect, and is sandwiched laterally between the p-doped and n-doped contact regions of which, preferably, one or both are made of another material, photo carrier generation in the doped regions can be reduced compared to a diode in which the doped and intrinsic regions are made of the same material of the optically active region. The photo carriers may be generated essentially in the intrinsic region such that the photo carriers are influenced by the electric field provided between the doped regions. Photo carriers in doped regions may only diffuse, i.e., they move slowly, compared to the photo carriers influenced by the electric field. As a result, the diode according to the invention may provide a larger opto-electrical bandwidth, which allows providing faster receivers.

The light-sensitive intrinsic region sandwiched laterally between the p-doped contact region and the n-doped contact region in a direction transverse to a direction of light propagation in the SiN waveguide is obtainable by sequentially providing the p-doped region in-situ doped and the n-doped region in-situ doped such that the intrinsic region has a maximal lateral extension between two lateral ends of the intrinsic region of equal to or below 300 nm, preferably equal to or below 200 nm, more preferably equal to or below 150 nm, and such that the intrinsic region is substantially not unintentionally doped when producing the diode.

The photodiode may include more than one p-doped contact region and/or more than one n-doped contact region. The p-doped contact regions may be stacked above each other forming an overall p-doped contact region in form of a material stack of p-doped contact regions, e.g., made of different materials and/or including different doping concentrations and/or different dopants. The n-doped contact regions may be stacked above each other forming an overall n-doped contact region in form of a material stack of n-doped contact regions, e.g., made of different materials and/or including different doping concentrations and/or different dopants.

The maximal vertical extension of the light-sensitive region, i.e., its vertical height along the vertical stacking direction, may be, for example, below 1000 nm, e.g., about 400 nm, e.g., 400 nm +/- 10 %, or between 300 nm and 400 nm. A maximal vertical extension of below 1000 nm is preferred to enable use of a contact scheme of standard backend-of-line processes. A contact scheme of standard backend-of-line processes may involve making use of tungsten or copper plugs. Preferably, a lower limit of a vertical extension of the light-sensitive region is 100 nm to 150 nm to ensure sufficient crystalline quality of the light-sensitive region for detecting electromagnetic radiation with the photodiode.

The p-doped contact region may be doped with, for example, boron atoms. The n-doped contact region may be doped with, for example, phosphorus atoms. Other dopants may be used for doping the n-doped contact region and/or the p-doped contact region. The doped contact regions may have, for example, a doping concentration of more than 5×10¹⁹ atoms/cm³, e.g., more than 10×²⁰ atoms/cm³.

The photodetector may comprise a bottom layer or substrate arranged below the photodiode. The bottom layer may be made of, for example, Si or SiGe. The bottom layer may be, for example, a bulk wafer or a waveguide. The bottom layer may be arranged and/or embedded on top of a buried oxide (BOX) layer, e.g., a SOI BOX layer, i.e., a BOX layer of a SOI substrate. The BOX layer may be made from, for example, silicon dioxide (SiO₂).

A silicide layer may be arranged on a top surface of each of the p-doped contact region and the n-doped contact region. The silicide layers may allow low ohmic contacting the doped contact regions with electrodes. The silicide layers may be metal silicide layers. The metal silicide layers may be made, for example, of cobalt-disilicide (CoSi₂) or nickel silicide (NiSi). Nickel-based silicide layers may allow for reducing thermal budget. The silicide layers may be arranged such that they are not in direct contact with the light-sensitive region. The silicide layer arranged on the top surface of the p-doped contact region may be arranged such that it is not in direct contact with the silicide layer arranged on the top surface of the n-doped contact region.

Preferably, the light-sensitive region has a lateral width of 150 nm or less or even 100 nm or less. Preferably, the light-sensitive region has a lateral width of at least 20 nm. A photodetector comprising a sensitive region has a lateral width of 150 nm or less and/or of at least 20nm may have an opto-electrical -3 dB bandwidth far beyond 100 GHz, e.g., of 200 GHz or more. Achieving opto-electrical -3 dB bandwidth far beyond 100 GHz is further enabled by providing in-situ p-doped and n-doped contact regions. Accordingly, ion-implantation can be waived and unintended doping of the intrinsically doped light-sensitive region can be reduced or even prevented. This is especially beneficial as minority carrier diffusion can be efficiently suppressed. Moreover, the performance of the photodetector is further improved by providing a direct contact between the SiN waveguide and light-sensitive region yielding an improved coupling efficiency from SiN waveguide to the light-sensitive region.

Preferably, the p-doped contact region and the n-doped contact region comprise Si and the light-sensitive region comprises Ge. This has the advantage that the photodetector can be fabricated using standard Si technology techniques such as CMOS or BiCMOS lines. Moreover Ge is preferred for the light-sensitive region due to its better light absorption behaviour compared to Si in the wavelength range of 0.8 µm to 1.65 µm. Accordingly, it is preferred that the photodiode is a PIN photodiode with p-Si - i-Ge - n-Si. Yet, it is also possible that the binary alloy SiGe is used in the p-doped and n-doped contact regions. The light-sensitive region may be made of Ge, SiGe, or GeSn.

Preferably, the light-sensitive region comprises an active material layer that is optically active and a capping layer arranged on top of the active material layer along the vertical stacking direction. It is thus preferred that, if present, the capping layer forms the common upper interface at which the light-sensitive region is in direct contact with the SiN waveguide. Preferably, the capping layer is configured for protecting the active material layer. Preferably, the capping layer has a thickness along the vertical stacking direction of no more than 100 nm, e.g., of 10 nm to 100 nm. A thickness along the vertical stacking direction of no more than 100 nm is preferred to ensure efficient coupling between the SiN waveguide and the active material layer through the capping layer. Moreover, a thickness along the vertical stacking direction of no more than 100 nm is preferred to provide sufficient protection of the active material layer by the capping layer. For example, the active material layer be made of or may comprise Ge and the capping layer may be made of or may comprise Si.

For fabricating the light-sensitive region comprising an active material layer and a capping layer, an insulating material layer may be provided having an insulating material layer window, e.g., formed as a trench. The insulating material layer may be for example be SiO₂. The active material layer may be fabricated by filling the insulating material layer window using selective epitaxy, e.g., selective Ge epitaxy. Alternatively, differential epitaxy may be used for fabricating the active material layer.

Preferably, the insulating material layer window is not completely filled with the active material layer by means of epitaxy but a step is created to the insulating material layer that, preferably, has a height of 10 nm to 100 nm. The capping layer may then be fabricated on top of the active material layer by employing selective or differential epitaxy to have a thickness of 10 nm to 100 nm. Thereby, the active material layer is covered by the capping layer along the vertical stacking direction. Alternatively, the active material layer present in the insulating material layer window may be etched to create a step to the insulating material layer. The thereby created gap can be filled with the material of the capping material.

Preferably, the capping layer is made of Si and selective or differential Si epitaxy is employed for fabricating the capping layer. For restoring a smooth, e.g., planar, outer surface of the light-sensitive region and/or of the insulating material layer, chemical-mechanical polishing (CMP) may be employed. In particular, CMP of the outer surface of the insulating material layer may be beneficial in case differential epitaxy instead of selective epitaxy is employed to expose again the outer surface of the insulating material layer before applying the SiN layer on top of the insulating material layer.

Preferably, the common upper interface between the light-sensitive region and the SiN waveguide is substantially planar. Alternatively, the common upper interface between the light-sensitive region and the SiN waveguide may be concavely curved along the vertical stacking direction. A concavely curved shape of the light-sensitive region may include a facet form which may originate from the crystalline properties of the material forming the light-sensitive region, e.g., of germanium. A planar common upper interface may be preferred if a substantially homogeneous field distribution within the light-sensitive region is desired. Furthermore, a planar common upper interface may lead to a reduced leakage current. A concavely curved common upper interface may provide improved coupling between the SiN waveguide and the light-sensitive region due to the larger interface length.

Preferably, a lateral width of the SiN waveguide along the lateral stacking direction corresponds to the lateral width of the light-sensitive region or is larger than the lateral width of the light-sensitive region. Preferably, a lateral width of the SiN waveguide is between 200 nm and 400 nm in dependence on the lateral width of the light-sensitive region. Such a SiN waveguide may provide efficient mode confinement for efficiently guiding electromagnetic radiation in the wavelength range of 0.8 µm to 1.65 µm. For example, if a light-sensitive region is fabricated with a lateral width of 50 nm to 100 nm width, with in-situ p-doped and n-doped contact regions of 50 nm to 100 nm on each side, and when considering a margin of about 50 nm on each side of the photodiode, 300 nm to 400 nm lateral width of the SiN waveguide on top of the light-sensitive region may be beneficial. Such a thickness is also compatible to optical modes in the wavelength range of 0.8 µm to 1.65 µm within a SiN waveguide.

It is particularly preferred that a lateral width of the SiN waveguide along the lateral stacking direction exceeds the lateral width of light-sensitive region on both sides by at least 20 nm, preferably, by at least 50 nm. In particular, it is preferred that the lateral width of the SiN waveguide is by up to 50 nm larger than the lateral width of the photodiode. It may be even beneficial for some applications if the lateral width of the SiN waveguide is by up to 100 nm larger than the lateral width of the photodiode

For the photodetector, it is preferred that the p-doped contact region comprises along the vertical stacking direction a p-doped connector region, a p-doped central region and a laterally protruding p-doped edge portion. The laterally protruding p-doped edge portion, preferably, has a larger lateral width along the lateral stacking direction than the p-doped central portion of the p-doped contact region. Additionally or alternatively, the n-doped contact region comprises along the vertical stacking direction a n-doped connector region, a n-doped central region and a laterally protruding n-doped edge portion. The laterally protruding n-doped edge portion, preferably, has a larger lateral width along the lateral stacking direction than the n-doped central portion of the n-doped contact region. Laterally protruding p-doped and n-doped edge portions have the advantage that formed silicide, e.g., cobalt or nickel, is kept at a distance from the optical field in the SiN waveguide.

In particular, in a photodetector comprising a photodiode with laterally protruding p-doped and n-doped edge portions, it is preferred, that a height of the laterally protruding p-doped edge portion and/or laterally protruding n-doped edge portion along the vertical stacking direction is equal to or smaller than a height of the light sensitive region along the vertical stacking direction. Thereby, the parasitic capacitance originated by the protruding vertical offshoots as present in the some known devices can be prevented, which may be beneficial for the RC time constant and thus the opto-electrical bandwidths of the photodiode. Preferably, the SiN waveguide is in contact with at least a part of the laterally protruding p-doped edge portion and/or at least a part of the laterally protruding n-doped edge portion.

Preferably, the photodetector comprises a Si waveguide that comprises Si and that is arranged below the photodiode along the stacking direction forming a common lower interface with the photodiode at which the Si waveguide is in direct contact with at least a part of the light sensitive region. For example, the photodiode may have a lower coupling surface that is opposite to an upper coupling surface and wherein the photodetector comprises a Si waveguide that comprises Si and that is coupled to the photodiode on its lower coupling surface and in direct contact with at least a part of the light sensitive region. Thereby, a double waveguide connection can be realised. The Si waveguide and the SiN waveguide may be arranged in different photonic planes of a photonic intergraded circuit. Preferably, the Si waveguide has a width along the lateral stacking direction that is equal to or larger than a lateral width of the photodiode.

The invention also relates to a photonic integrated circuit or an electronic photonic circuit comprising the photodetector as described before.

The invention furthermore relates to a method for fabricating a photodetector. The method comprises the steps of
- fabricating a lateral photodiode comprising an in-situ p-doped contact region, an in-situ n-doped contact region and, sandwiched between the p-doped contact region and n-doped contact region along a lateral stacking direction, an intrinsically doped light-sensitive region, the light-sensitive region having a lateral width along the lateral stacking direction of 300 nm or less, and
- fabricating a SiN waveguide comprising SiN and being configured to guide electromagnetic radiation along a propagation direction, the SiN waveguide being arranged on top of the lateral photodiode along a vertical stacking direction that is perpendicular to the lateral stacking direction, such that at least a part of the light-sensitive region and at least a part of the SiN waveguide form a common upper interface at which the light-sensitive region is in direct contact with the SiN waveguide.

The method may be employed for fabricating the photodetector as described before. The method allows for direct contact between the light-sensitive region and the SiN waveguide, i.e., there is no gap present between them. Thereby, a coupling efficiency from SiN waveguide to the light-sensitive region can be improved. This may be realised in the method by the deposition of a SiN layer before the in-situ p-doped and n-doped contact regions are deposited. The deposition of the SiN layer is thus not limited by thermal budget. This means that the SiN layer, which is later on patterned to serve as optical waveguide can be deposited by LPCVD processes which are particularly suitable for fabricating low loss SiN waveguides operating at the C-band wavelength region. Alternative processes such as PECVD may be used, however, LPCVD is preferred due to less hydrogen incorporation. Less hydrogen incorporation is particularly beneficial for fabrication of low-loss waveguides in a plurality of the optical communication bands, i.e., in particular, in the 1.55 µm wavelength regions (C-band).

Preferably, in the method fabricating the photodiode comprises
a) providing a photodetector intermediate product comprising an intrinsically-doped light-sensitive region having a lateral width of 300 nm or less that is embedded with its lateral sides into an insulating material layer that is arranged on a substrate, wherein with its top side facing away from the substrate along the vertical stacking direction, the light-sensitive region is in contact with a SiN hardmask covering the insulating material layer with the embedded light-sensitive region,
b) creating a first window in the SiN hardmask at a first predefined distance to a first one of the lateral sides of the light-sensitive region,
c) removing the insulating material layer exposed by the first window by underetching such that the first one of the lateral sides of the light-sensitive region is exposed and a first cavity is formed next to the insulating material layer,
d) epitaxially growing an in-situ p-doped layer covering at least parts of the SiN hardmask and the first one of the lateral sides of the light-sensitive region such that a laterally protruding p-doped edge portion is formed within the first cavity and in con-tact with the SiN hardmask and wherein in the laterally protruding p-doped edge portion, the p-doped contact region has a larger lateral width along the lateral stacking direction than a p-doped central portion of the in-situ p-doped layer,
e) filling the first cavity with an insulating material and exposing an upper surface of the SiN hardmask along the vertical stacking direction,
f) creating a second window at a second predefined distance to a second one of the lateral sides of the light-sensitive region such that the light-sensitive region is positioned between the first window and the second window, wherein by creating the first and second windows, the SiN waveguide is formed on top of the photodiode along the vertical stacking direction,
g) repeating steps c) to f) analogously for the second window, wherein instead of epitaxially growing an in-situ p-doped layer as per step d), an in-situ n-doped layer is epitaxially grown,
h) removing those parts of the in-situ p-doped layer and the in-situ n-doped layer that cover the lateral sides of the SiN waveguide, thereby forming the in-situ p-doped contact region and the in-situ n-doped contact region of the photodiode, respectively,
i) removing the insulating material within the first cavity and the second cavity to expose the in-situ p-doped contact region and the in-situ n-doped contact region of the photodiode,
   and
j) performing silicide formation of the in-situ p-doped contact region and the in-situ n-doped contact region.

Additionally or alternatively, in the method, providing the photodetector intermediate product may comprise
- before applying the SiN hardmask on top of the insulating material layer with the embedded light-sensitive region, chemically and/or mechanically polishing an outer surface of the insulating material layer with the embedded light-sensitive region along the vertical stacking direction to provide a smooth interface between the insulating material layer with the embedded light-sensitive region and the SiN hardmask.

Additionally or alternatively, in the method, providing the photodetector intermediate product may comprise fabricating the light-sensitive region in an insulating material layer window present in an insulating material layer.

Preferably, fabricating the light-sensitive region in an insulating material layer window of an insulating material layer comprises epitaxially fabricating an active material layer in the insulating material layerwindow and epitaxially fabricating a capping layer on top of the active material layer such that the active material layer is covered by the capping layer and thereby protected. In this case, the capping layer of the light-sensitive region forms the upper common interface between the light-sensitive region and the SiN waveguide applied on top of the light-sensitive region along the vertical stacking direction. Epitaxially fabricating the active material layer may include selective Ge epitaxy. Epitaxially fabricating the capping layer on top of the active material layer may include selective or differential Si epitaxy.

Creating a first and/or second window in the SiN hardmask at a predefined distance to a first one of the lateral sides of the light-sensitive region, may include a distance of 100 nm to 300 nm. The first and second window preferably extend along the length of the light-sensitive region and has a lateral width of, e.g., 50 nm or more. Yet, also a lateral width of 100 nm or more, e.g., 130 nm or more may be used.

Preferably, for removing the insulating material layer exposed by the first window by underetching such that the first one of the lateral sides of the light-sensitive region is exposed an oxide wet etching is employed. Preferably, creating a first and/or second window in the SiN hardmask includes patterning of the SiN hardmask to define the area of the first and/or second window. Preferably, the insulating material for filling the first and/or second window is SiO₂. Preferably, removing those parts of the in-situ p-doped layer and the in-situ n-doped layer that cover the lateral sides of the SiN hardmask may include Si dry etching. Preferably, removing the insulating material within the first window and the second window to expose the in-situ p-doped layer and the in-situ n-doped layer may include maskless wet-etch. Preferably, the SiN hardmask is fabricated to have a thickness of 200 nm to 500 nm.

Additionally or alternatively, in the method, fabricating the SiN waveguide comprises
- exposing an outer surface of the SiN hardmask that faces along the vertical stacking direction, and
- patterning the SiN hardmask to define the shape of the SiN waveguide arranged on top of the photodiode. For example, exposing an outer surface of the SiN hardmask that faces away from the substrate can be performed using CMP and dry etch, e.g., Si reactive ion etching. Thereby the Si on the SiN hardmask outer surface can be removed to restore a smooth surface of SiN hardmask that enables the patterning of the SiN hardmask.

The invention also relates to a use of the photodetector as described before for detection of electromagnetic radiation in the wavelength range of 0.8 µm to 1.65 µm.

It shall be understood that the photodiode of claim 1, the photonic integrated circuit or an electronic photonic circuit of claim 10, the fabrication method of claim 11 and the use of the photodetector of claim 15 have similar and/or identical preferred embodiments, in particular, as defined in the dependent claims.

It shall be understood that a preferred embodiment of the present invention can also be any combination of the dependent claims or above embodiments with the respective independent claim.

These and other aspects of the invention will be apparent from and elucidated with reference to the embodiments described hereinafter.

### BRIEF DESCRIPTION OF THE DRAWINGS

In the following drawings:
Fig. 1: schematically and exemplary shows a photodetector in a cross-sectional view;
Fig. 2: schematically and exemplary shows a photodetector comprising a SiN waveguide arranged on top of and coupled to a lateral photodiode in a cross sectional view;
Fig. 3: schematically and exemplary shows a photodetector in a plan view;
Fig. 4: schematically and exemplary shows the photodetector of Fig. 3 in a cross-sectional view;
Fig. 5: schematically and exemplary shows the photodetector of Fig. 3 in a longitudinal sectional view;
Figs. 6 to 15: schematically and exemplary show several different intermediate products that are fabricated when conducting a method for fabricating a photodetector comprising a Ge fin photodiode and a SiN waveguide;

### DETAILED DESCRIPTION OF EMBODIMENTS

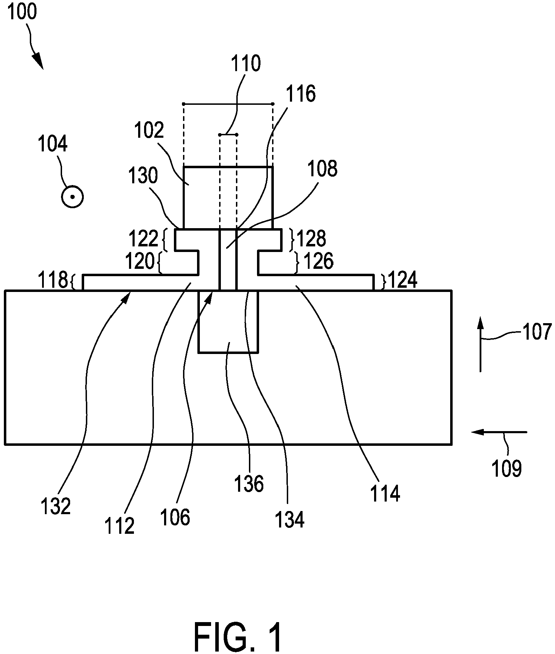

Figure 1 schematically and exemplary shows a photodetector 100 in a cross-sectional view. The photodetector 100 is configured for detecting electromagnetic radiation. In particular, the photodetector 100 may be used for detecting electromagnetic radiation in a wavelength range of 0.8 µm to 1.65 µm typically used in optical communication.

The photodetector 100 comprises a SiN waveguide 102 that is configured to guide electromagnetic radiation along a propagation direction 104 that is perpendicular to the cross-sectional view of figure 1. The SiN waveguide 102 is arranged on top of a lateral photodiode 106 along a vertical stacking direction 107. The lateral photodiode comprises a Ge fin 108 as a light-sensitive region 108. The Ge fin 108 has a lateral width 110 of 200 nm along a lateral stacking direction 109. In alternative embodiments, the light-sensitive region 108 may have a lateral width of 300 nm or less and of at least 20 nm. For example, the light-sensitive region 108 may have the lateral width of 100 nm to 150 nm. The light-sensitive region 108 is intrinsically doped. The light-sensitive region 108 may also be made of a different semiconductor material such as SiGe. In a preferred embodiment, the light-sensitive region 108 comprises a Ge fin as an active material layer and a Si capping layer arranged on top of the Ge fin along the vertical stacking direction. In this embodiment, the Si capping layer forms the common interface between the light-sensitive region and the SiN waveguide.

For implementing a lateral p-i-n junction along the lateral stacking direction 109, the intrinsically doped light-sensitive region 108 is sandwiched between an in-situ p-doped contact region 112 that is made of Si and an in-situ n-doped contact region 114 that is also made of Si. In other words, the in-situ p-doped contact region 112, the light-sensitive region 108 and the in-situ n-doped contact region 114 are arranged adjacent to each other in parallel along the lateral stacking direction 109 that is perpendicular to the vertical stacking direction 107. Since the p-doped contact region 112 and the n-doped contact region 114 are in-situ doped, the light-sensitive region 108 is substantially free from unintentional doping. Thereby and, in particular in combination with the comparatively small lateral width of the light-sensitive region 108, high opto-electrical -3 dB bandwidths of 100 GHz or more, e.g., of 200 GHz or more can be achieved with the photodetector 100.

The SiN waveguide 102 is in direct contact with the photodiode 106 forming an upper common interface 116, i.e., there is no other material layer in between the SiN waveguide 102 and the photodiode 106. Thereby, a coupling efficiency from the SiN waveguide 102 to the Ge fin 108 may be improved. Another feature of the photodetector 100 is that the p-doped contact region 112 and the n-doped contact region 114 both terminate at a height along the vertical stacking direction 107 of the upper common interface 116 between the photodiode 106 and the SiN waveguide 102. In other words, the p-doped contact region 112 and the n-doped contact region 114 have a height that corresponds to the height of the light-sensitive region or is smaller than the height of the light-sensitive region along the vertical stacking direction 107. With regard to a photodetector as known in the prior art that has vertical offshoots that protrude beyond the height of a photodiode itself, the photodetector 100 has the advantage that parasitic capacitance originating from such protruding offshoots can be prevented which is beneficial for the RC time constant and thus for achieving high bandwidths of 200 GHz or more with the photodiode 106.

The p-doped contact region 112 of the photodetector 100 comprises three different parts that are a p-doped connector region 118, a p-doped central region 120, and a laterally protruding p-doped edge portion 122. The p-doped connector region 118 serves for contacting the p-doped contact region 112 with a metal electrode via a metal connector (not shown). The p-doped central region has the smallest lateral width of the p-doped contact region 112 along the lateral stacking direction 109 and follows the p-doped connector region 118 in a direction towards the SiN waveguide 102. Following the p-doped central region 112 towards the SiN waveguide 102, the p-doped contact region 118 comprises the laterally protruding p-doped edge portion 122. The laterally protruding p-doped edge portion 122 can be considered as a lateral offshoot that is bent away laterally along the lateral stacking direction and with respect to the lateral side face of the light-sensitive region 108.

Like the p-doped contact region 112, the n-doped contact region 114 of the photodetector 100 comprises three parts that are a n-doped connector region 124, a n-doped central region 126, and a laterally protruding n-doped edge portion 128. The n-doped connector region 124, the n-doped central region 126 and the laterally protruding n-doped edge portion 128 are configured the same way as described for the p-doped contact region 112 but extending laterally in the opposite direction, i.e., mirrored with respect to the light-sensitive region 108.

The surfaces of the laterally protruding p-doped edge portion 122, the light-sensitive region 108, and the laterally protruding n-doped edge portion 128 that face towards the SiN waveguide 102 form an upper coupling surface 130 of the photodiode 106. The upper coupling surface 130 comprises the upper common interface 116 between the photodiode 106 and the SiN waveguide 102. Those surfaces of the p-doped connector region 118, the light-sensitive region 108, and the n-doped connector region 124 that are opposite to the upper coupling surface 130, form a lower coupling surface 132. Parts of the lower coupling surface 132 form a lower common interface 134 between the photodiode 106 and a Si waveguide 136 that is coupled to the light sensitive region 108 and arranged on the opposite side of the photodiode 106 compared to the SiN waveguide 102. Accordingly, the photodetector 100 includes a double waveguide configuration that includes the SiN waveguide 102 arranged on the upper coupling surface 130 of the photodiode 106 and the Si waveguide 136 arranged on the lower coupling surface 132 of the photodiode 106. The photodetector 100 is, thus, configured for detecting electromagnetic radiation propagating in two different photonic planes that may be arranged parallel to each other. For example, each of the photonic planes may comprise or may be configured as a photonic integrated circuit or an electronic photonic integrated circuit. The Si waveguide 136 is embedded into a silicon-on-insulator (SOI) base material that also contacts parts of the p-doped connector region 118 and the n-doped connector region 124 of the photodetector 100. Accordingly, the photodetector 100 may be fabricated using standard Si technology, e.g. in a CMOS or BiCMOS process.

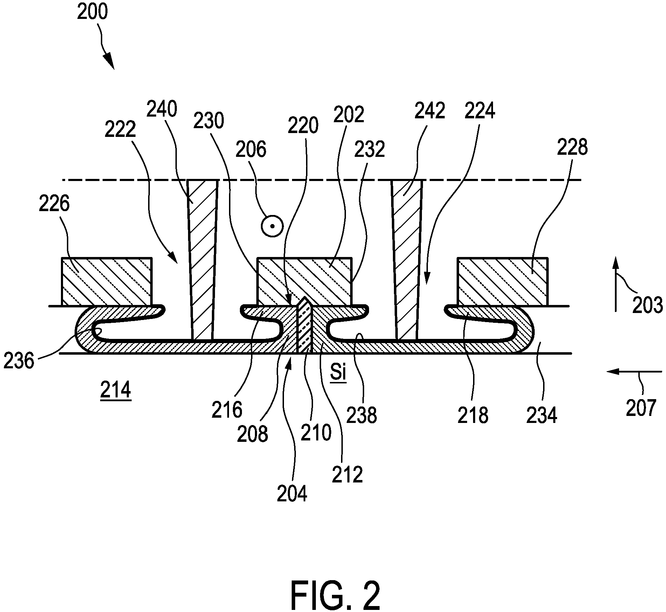

Figure 2 schematically and exemplary shows a photodetector 200 comprising a SiN waveguide 202 arranged on top of and coupled to a lateral photodiode 204 along a vertical stacking direction 203 in a cross sectional view. The SiN waveguide 202 is configured for guiding electromagnetic radiation along a propagation direction 206. Electromagnetic radiation propagating through the SiN waveguide 202 can be detected by the photodiode 204 that comprises a p-doped contact region 208, a light sensitive region 210 and a n-doped contact region 212 that are arranged in parallel to each along a lateral stacking direction 207 that is perpendicular to the vertical stacking direction 203. The light-sensitive region 210 is configured as a Ge fin and has a lateral width along the lateral stacking direction 207 of 100 nm. The light-sensitive region 210 may alternatively be formed by a Ge fin and a capping layer, e.g., made of Si, covering the Ge fin along the stacking direction. Alternatively, the light-sensitive region 210 may have a lateral width of 20 nm to 300 nm. Yet, it is preferred that the light-sensitive region 210 has a lateral width of 150 nm or less to achieve high opto-electrical -3 dB bandwidths of 200 GHz or more. The p-doped contact region 208 and the n-doped contact region 212 are made of Si.

As the photodetector 100 described with reference to figure 1, the n-doped contact region 212 and the p-doped contact region 208 of the photodiode 204, each comprise a connector region, a central region and a laterally protruding edge portion. The connector regions are in contact with a silicon substrate 214. The p-doped laterally protruding edge portion 216 together with the light sensitive region 210 and the laterally protruding n-doped edge portion 218 form an upper coupling surface 220 of the photodiode 204 on which the SiN waveguide 202 is arranged. In contrast to the upper coupling surface 130 of photodiode 106 described with reference to figure 1, the interface between the photodiode 204 and the SiN waveguide 202 is not planar but the light-sensitive region 210, i.e., the Ge fin, extends into the SiN waveguide 202. A height of the Ge fin 210 along the vertical stacking direction 203 is thus larger than a height of the n-doped contact region 212 and the p-doped contact region 208 of the photodiode 204.

The SiN waveguide 202 has been formed by patterning a SiN hardmask. Due to the fabrication of the SiN waveguide 202, the SiN waveguide 202 has lateral waveguide side faces 230, 232 that are substantially parallel to the vertical stacking direction 203 but may also be inclined with respect to the vertical stacking direction 203. In other words, the lateral waveguide side faces 230, 232 of the SiN waveguide are substantially parallel with respect to an interface between the p-doped or n-doped contact regions 208, 214 and the light-sensitive region 210, respectively.

As part of the SiN waveguide 202 preparation, first and second windows 222, 224 have been created in the SiN hardmask next to the SiN waveguide 202. These first and second windows 222, 224 are thus enclosed by remaining parts 226, 228 of that SiN hardmask and by the SiN waveguide 202.

The p-doped contact region 208 is covered by a first metal silicide layer 236 and the n-doped contact region 212 is covered by a second metal silicide layer 238. The first and second metal silicide layers 236, 238 can be made of AlCu or NiSi and serve for contacting the p-doped contact region 208 and the n-doped contact region 212 with first and second metal connectors 240, 242, respectively. The first and second metal connectors 240, 242 can be made of W and may connect the p-doped contact region 208 and the n-doped contact region 212 with first and second metal electrodes (not shown), respectively, that can be made of AlCu.

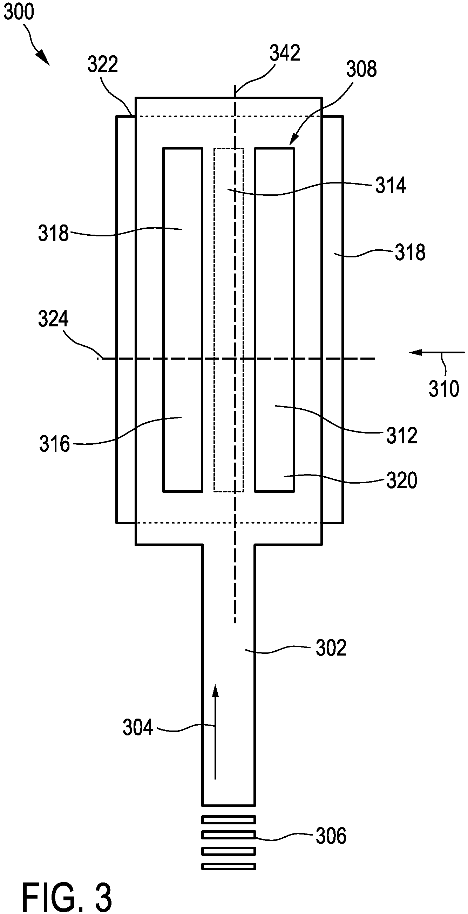

Figure 3 schematically and exemplary shows a photodetector 300 in a plan view. The photodetector 300 comprises a SiN waveguide 302 that is arranged and configured for guiding electromagnetic radiation along a propagation direction 304. The SiN waveguide 302 extends from a SiN grating coupler 306 that serves for fibre-to-chip coupling. Electromagnetic radiation propagating through the SiN waveguide 302 can be detected by the lateral photodiode 308 arranged below and coupled to the SiN waveguide 302. The lateral photodiode 308 comprises along a lateral stacking direction 310 perpendicular to the propagation direction 304 an in-situ p-doped contact region 312, an intrinsically doped light-sensitive region that here is configured as an intrinsic Ge fin 314 followed by an in-situ n-doped contact region 316. The photodiode 308 is arranged on a Si waveguide 318. The lateral width of the Si waveguide 318 along the lateral stacking direction 310 exceeds the lateral width of the photodiode 308 and the SiN waveguide 302. On each side of the SiN waveguide 302 along the lateral direction 310, there is a window, i.e. first and second windows 318, 320 that have been created by patterning a SiN hardmask 322 for fabricating the SiN waveguide 302.

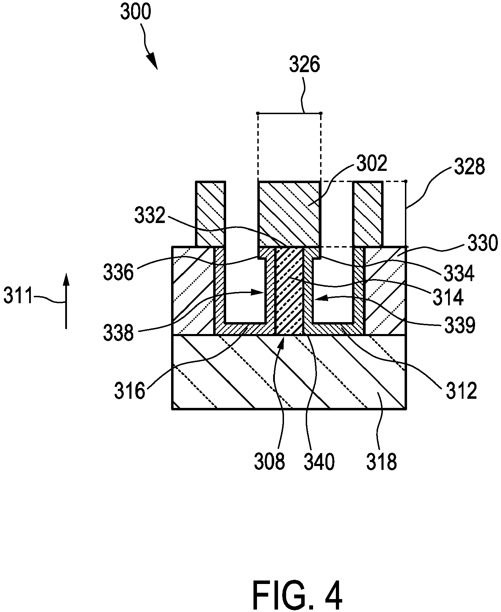

Figure 4 schematically and exemplary shows the photodetector 300 in a cross-sectional view along a cut through photodetector 300 that is indicated by a first dashed line 324 along the lateral stacking direction 310 as indicated in figure 3. As can be seen in figure 4, the SiN waveguide 302 has a lateral width 326 along the lateral stacking direction 310 perpendicular to a vertical stacking direction 311 of 200 nm. Alternatively, the SiN waveguide 302 may have a lateral width 326 of 100 nm to 700 nm. The SiN waveguide 302 has a height 328 along the vertical stacking direction 311 of 120 nm. Alternatively, the SiN waveguide 302 may have a height 328 of 30 nm to 500 nm. The photodiode 308 is arranged on top of the Si waveguide 318 along the vertical stacking direction 311 and embedded into a SiO₂ layer 330. Accordingly, the SiO₂ layer 330 is arranged between the Si waveguide 318 embedded into a SOI based material (not shown) and the SiN hardmask 322 and the SiN waveguide 302.

The photodiode 308 comprised of the Ge fin 314 laterally sandwiched between the in-situ p-doped contact region 312 and the in-situ n-doped contact region 316 along the lateral stacking direction 310 is in direct contact with its upper coupling surface 332 to the SiN waveguide 302. The upper coupling surface 332 is formed by the Ge fin 314 as well as a laterally protruding p-doped edge portion 334 of the p-doped contact region 314 and a laterally protruding end-doped edge portion 336 of the n-doped contact region 316. As can be seen in figure 4, the laterally protruding p-doped edge portion 334 protrudes along the lateral stacking direction 310 away from the Ge fin 314, i.e. perpendicular to a side face of the Ge fin 314. Likewise, the laterally protruding n-doped edge portion 336 protrudes along the opposite direction away from the Ge fin 314, i.e. perpendicular a side face of the Ge fin 314. In the regions of the lateral protruding p-doped edge portion 334 and the lateral protruding n-doped edge portion 336, the photodiode 308 has a larger lateral width along the lateral stacking direction 310 as in respective n-doped or p-doped central parts 338, 339. The respective n-doped or p-doped central parts 338, 339 follow the laterally protruding n-doped and p-doped edge portions 334, 336, respectively, in a direction towards a lower coupling surface 340 of the photodiode 308.

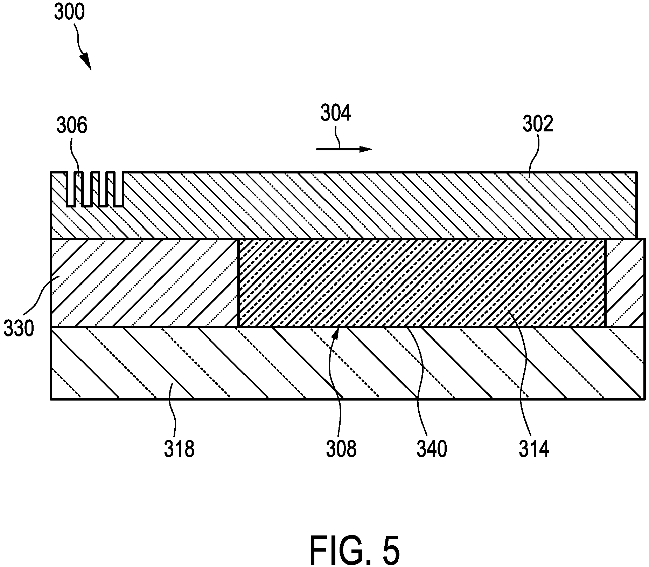

Figure 5 schematically and exemplary shows the photodetector 300 and a longitudinal sectional view along a cut through the photodetector 300 that is indicated by a second dashed line 342 running parallel to the propagation direction 304 in figure 3. In this longitudinal sectional view of figure 5, it can be seen that the SiN waveguide 302 is in direct contact with the photodiode's coupling surface 332 that is partly formed by Ge fin 314 thereby providing efficient coupling of electromagnetic radiation propagating through the SiN waveguide 302 along the propagation direction 304. The SiN waveguide 302 extends from the SiN grating coupler 306 to the photodiode 308 comprising the Ge fin 314. The photodiode 308 is embedded into the SiO₂ layer 330. With its lower coupling surface 340, the photodiode 308 is in direct contact with the Si waveguide 318.

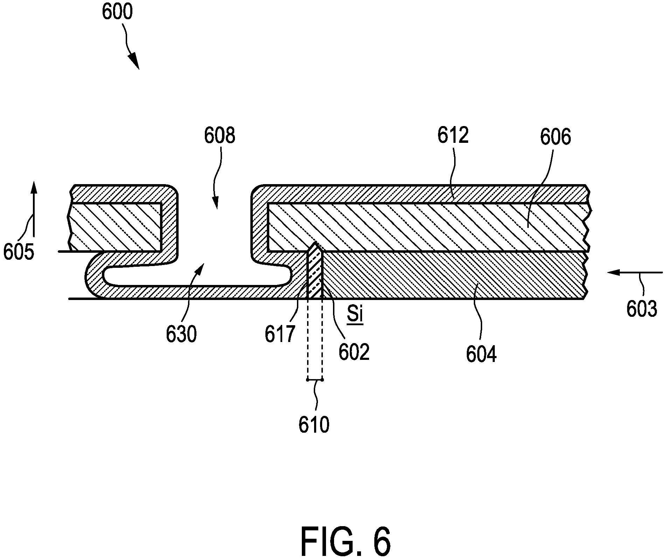

Figures 6 to 15 show several different intermediate products that are fabricated when conducting a method for fabricating a photodetector comprising a Ge fin photodiode 641 and a SiN waveguide 644 as described in the following. For example, by conducting the method steps of the method for fabricating a photodetector, the photodetector 100, 200, 300 as described with reference to figures 1 to 5, respectively, can be fabricated.

Figure 6 schematically shows a first intermediate product 600 of a method for fabricating a photodetector comprising a Ge fin photodiode 641. For fabricating the first intermediate product 600, a Ge fin 602 is fabricated as an intrinsically doped light sensitive region of the photodiode 641 by employing selective Ge fin epitaxy in a SiO₂ window in a SiO₂ layer 604. Accordingly, for fabricating the Ge fin 602, Ge is selectively deposited in a narrow SiO₂ window of a SiO₂ layer 604. It may be beneficial, to fabricate the Ge fin to extend not up to the height of the SiO₂ window in a SiO₂ layer 604 but to stop before, i.e., having a smaller height than the SiO₂ window. Thereby, a step is created from the Ge fin to the SiO₂ layer. This step can be filled by a capping layer material, e.g., Si, to form a capping layer that serves for protecting the Ge fin. The capping layer, preferably, is fabricated to have a thickness of 10 nm to 100 nm. For example, the capping layer may be fabricated using selective Si epitaxy or differential Si epitaxy. In particular, in case differential Si epitaxy is employed, CMP may be used to remove additional Si from the SiO₂ layer to expose again the outer SiO₂ layer surface. An alternative process of fabricating a light-sensitive region comprising an active material layer and a capping layer includes etching the active material layer towards the substrate to create a step to the SiO₂ layer. This step can then be filled with the material of the capping layer to form the capping layer on top of the active material layer along the stacking direction.

Preferably, the Ge fin 602 is fabricated to have a lateral width 610 of 300 nm or less and particularly preferred of 20 nm to 150 nm along a lateral stacking direction 603. As can be seen in Fig. 6, the upper surface 619 of the Ge fin 602 facing towards the SiN layer 606 along a vertical stacking direction 605 is not planar but concavely curved towards the vertical stacking direction 605 such that also the interface between the Ge fin 602 and the SiN layer 606 is concavely curved. Yet, it is also possible to first apply CMP to provide a planar surface with the SiO₂ layer 604 and the Ge fin 602 on which the SiN layer 606 can be deposited. In this case, the interface between the Ge fin 602 and the SiN layer 606 is substantially planar.

After fabricating the Ge fin 602, a SiN layer 606 is deposited on the SiO₂ layer 604 with a thickness of 200 nm to 500 nm. The SiN layer 606 can be deposited using on the SiO₂ layer 604 using low-pressure chemical vapour deposition (LPCVD) which generally occurs at comparatively high temperatures of about 700 °C. A SiN layer 606 deposited by LPCVD can also be denoted as a thermal nitride layer. A thermal nitride layer is preferred since it enables fabrication of a photodetector comprising lateral photodiode 641 and a SiN waveguide 644 that enables operation at an opto-electrical -3 dB bandwidth of 200 GHz or beyond. In particular, the SiN layer 606 deposited by LPCVD can be later on patterned to serve as a SiN waveguide. An accordingly fabricated SiN waveguide can be operated with comparatively low loss at the C-band wavelength region, i.e., 1.5 µm.

This possible since with the method for fabricating a photodetector described herein, first the SiN layer 606 is deposited and only afterwards the photodiode 641 is created, and in particular, the photodiode's in-situ p-doped contact region and in-situ n-doped contact region. The fabrication of the photodiode 641 does therefore not provide thermal budget constraints to the deposition of the SiN layer 606. That is, if the photodiode 641 would be fabricated before the deposition of the SiN layer 606 much lower temperatures and a different method compared to the LPCVD would need to be employed in order to not to destroy the photodiode 641.

In contrast, when using plasma enhanced chemical vapour deposition (PECVD), much lower temperatures would need to be employed yet operating with much less performance in the C-band wavelength region. Therefore, the ability to use LPCVD for SiN layer 606 deposition constitutes a significant advantage of the present method for fabricating a photodetector.

The SiN layer 606 is opened aside the Ge fin 602 to create a first window 608. Preferably, the first window 608 is created parallel to the Ge fin 602 at a distance of 100 nm to 300nm. The SiN layer 606 serves as a hardmask for oxide wet-etch, which is applied to laterally underetch the SiN layer 606 in the area of the first window 608. The wet-etch reaches the Ge fin 602 to expose its first sidewall 617 that faces towards the first window 608. Thereby, a first cavity 630 is created. Since the first sidewall 617 of the Ge fin 602 is exposed it is possible to apply isotropic Ge etching to further reduce the lateral width of the Ge fin 602. For example, the lateral width of the Ge fin 602 may be reduced by 10 nm 50 nm to obtain an evener thinner Ge fin 602.

Since, as stated before, the SiN layer 606 is deposited before any doping for the photodiode 641 thermal budget constraints can be relieved and the SiN layer 606 may be deposited prior to any doping using LPCVD. Accordingly, after creation of the first cavity and with the SiN layer 606 already present, differential epitaxy of in-situ p-doped Si is employed resulting in an in-situ p-doped Si layer 612 covering the exposed first sidewall 617 of the Ge fin 602 as well as the free surfaces of the SiN layer 606 and SiO₂ layer 604. The in-situ p-doped Si layer 612 serves for forming the p-doped contact region of the photodiode 641.

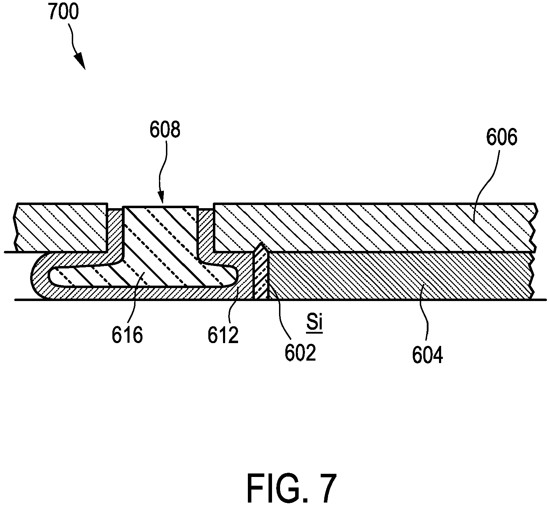

Figure 7 shows a second intermediate product 700 that is obtained by further processing the first intermediate product 600 described with reference to figure 6. For arriving at the second intermediate product 700, the first intermediate product 600 is overfilled with SiO₂ 616. Subsequently, CMP and dry etching are employed to remove the in-situ p-doped Si layer 612 outside the etched trench forming the first window 608. Thereby, a planar surface of the SiN layer 606 is restored which enables the patterning of the SiN layer 606 on the opposite side of the Ge fin 602 for forming a n-doped contact region of the photodiode 641.

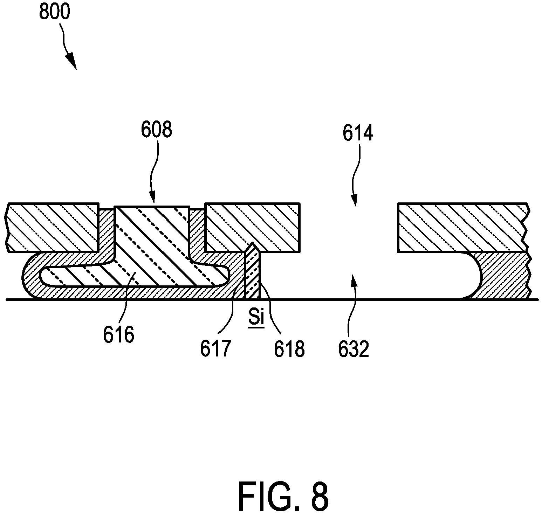

Figure 8 shows a third intermediate product 800 that is obtained by further processing the second intermediate product 700 described with reference to figure 7. For fabricating the third intermediate product 800, patterning of SiN hardmask 606 and wet-etch oxide of the second intermediate product 700 has been conducted to define the area of a second window 614. For patterning of SiN hardmask 606 and wet-etch oxide a resist is employed since first window 608 shall remain filled with SiO₂616. Due to the wet-etch in the second window 614, a second cavity 632 is created and the other sidewall 618 of the Ge fin 602 is exposed that faces towards the second cavity 632. Again, it is possible to apply isotropic Ge etching to further reduce the lateral width of the Ge fin 602. For example, the lateral width of the Ge fin 602 may be further reduced by 10 nm 50 nm.

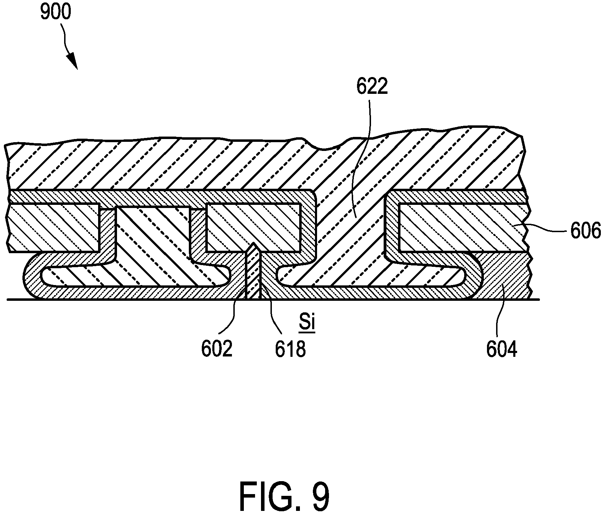

Figure 9 shows a fourth intermediate product 900 that is obtained by further processing the third intermediate product 800 described with reference to figure 8. For fabricating the fourth intermediate product 900, first, differential in-situ doped Si epitaxy is employed for applying an in-situ n-doped Si layer 620 covering the exposed second sidewall 618 of the Ge fin 602 as well as the free surfaces of the SiN layer 606 and SiO₂ layer 604. The in-situ n-doped Si layer 620 serves for forming the n-doped contact region of the photodiode 641. Subsequently, the second cavity 632 is filled with SiO₂ 622 by overfilling.

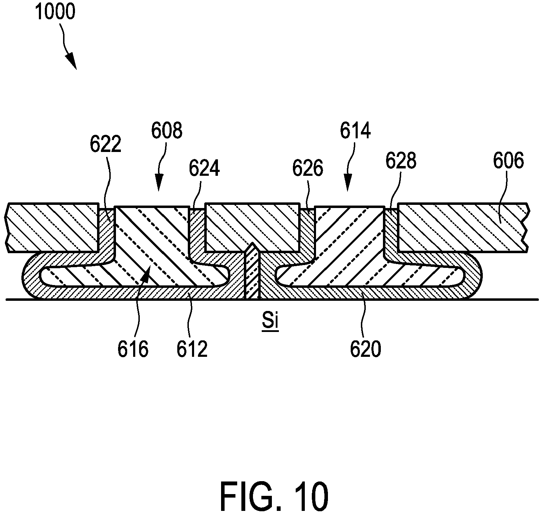

Figure 10 shows a fifth intermediate product 1000 that is obtained by further processing the fourth intermediate product 900 described with reference to figure 9. To obtain the fifth intermediate product 1000, the fourth intermediate product 900 is further processed using SiO₂ CMP and Si dry-etch to remove the SiO₂ 622 and the in-situ n-doped Si layer 620 on the SiN layer 606. Accordingly, in the fifth intermediate product 1000, the SiO₂ 622 and the in-situ n-doped Si layer 620 are only present inside the second cavity 632. Moreover, in the first window 608, parts of the SiO₂ 612 and the in-situ p-doped Si layer 616 are exposed again.

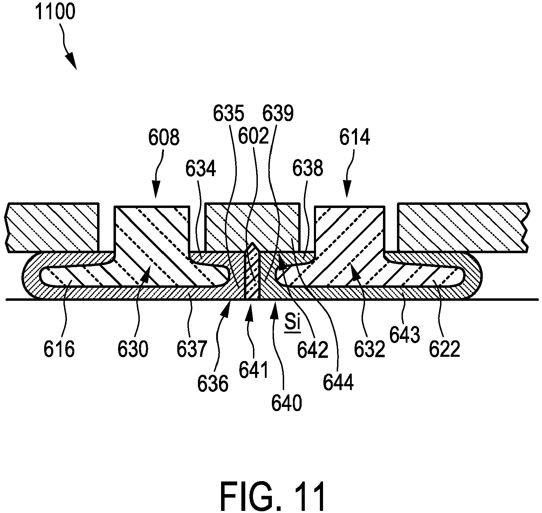

Figure 11 shows a sixth intermediate product 1100 that is obtained by further processing the fifth intermediate product 1000 described with reference to figure 10. For fabricating the sixth intermediate product 1100, the fifth intermediate product 1000 has been processed using Si dry-etch to remove protruding, vertical Si offshoots 622, 624, 626, 628 (denoted in figure 10). Removing the Si offshoots 622, 624, 626, 628 is possible due to the high selectivity between Si and SiO₂. Because of the high selectivity between Si and SiO₂, it is possible to fully remove the Si offshoots 622, 624, 626, 628 with the SiO₂ 616 remaining in the first window 608 and the underlying first cavity 630 as well as with the SiO₂ 622 remaining in the second window 614 and the underlying second cavity 632. Moreover, thereby, a laterally protruding p-doped edge portion 634 of the in-situ p-doped contact region 636 is formed that extends laterally away from the Ge fin 602 along the lateral stacking direction 603. Furthermore, a laterally protruding n-doped region 638 of the in-situ n-doped contact region 640 is formed that extends laterally away from the Ge fin 602, however, in the opposite direction compared to the laterally protruding p-doped edge portion 634. Thereby, in-situ p-doped contact region 636, the Ge fin 602 and the in-situ n-doped contact region 640 form the photodiode 641. The in-situ p-doped contact region 636 comprises the laterally protruding p-doped edge portion 634 as well as a p-doped central region 635 and a p-doped connector region 637. Correspondingly, the in-situ n-doped contact region 640 comprises the laterally protruding p-doped edge portion 638 as well as a n-doped central region 639 and a n-doped connector region 643. The laterally protruding p-doped edge portion 634, the laterally protruding p-doped edge portion 638 as well as the Ge fin 602 form an upper coupling surface 642 of the photodiode 641 on which the SiN waveguide 644 is arranged in direct contact with the Ge fin 602.

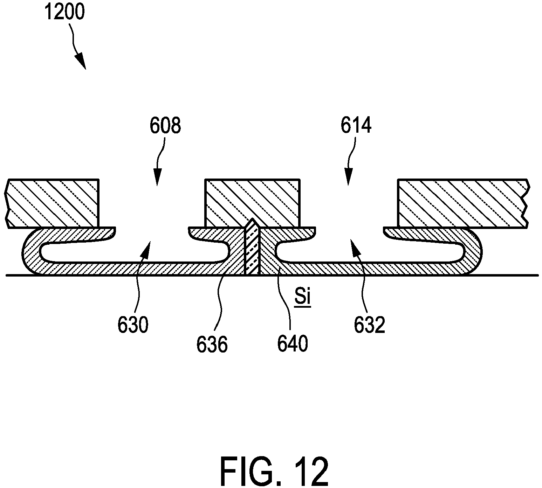

Figure 12 shows a seventh intermediate product 1200 that is obtained by further processing the sixth intermediate product 1100 described with reference to figure 11. For obtaining the seventh intermediate product 1200, the SiO₂ 616 in the first window 608 and the underlying first cavity 630 as well as the SiO₂ 622 in the second window 614 and the underlying first cavity 632 has been removed by wet-etch, e.g., maskless, of the sixth intermediate product 1100. Thereby, the in-situ p-doped contact region 636 and the in-situ n-doped contact region 640 are exposed which allows subsequent silicide formation.

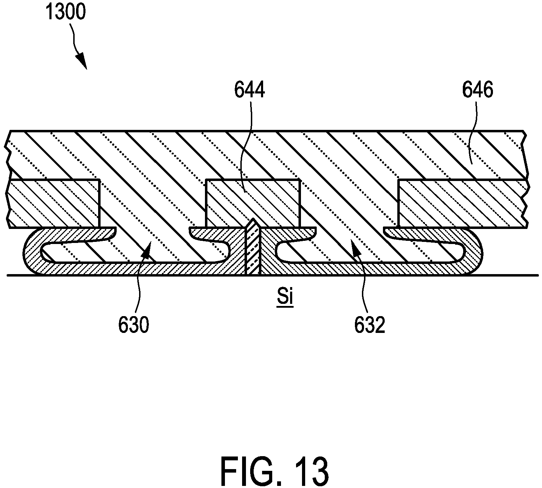

Figure 13 shows an eighth intermediate product 1300 that is obtained by further processing the seventh intermediate product 1200 described with reference to figure 12. The eighth intermediate product 1300 comprises a resist mask 646 applied on top of the SiN waveguide 644, the photodiode 641 and the first and second cavities 630, 632 accommodating the in-situ p-doped contact region 636 and the in-situ n-doped contact region 640, respectively. To arrive at the eighth intermediate product 1300, the resist mask 646 has thus been deposited onto the seventh intermediate product 1200 in the photodiode region and SiN hardmask regions outside the actual photodiode 641 have been removed by dry-etching. The resist mask 646 may further be used for the definition and patterning of the SiN waveguide 644. For example, the resist mask 646 may be used to define the shape of the SiN waveguide 644 by dry-etching. For example, the resist mask 646 may be used to decrease the lateral width 648 of the SiN waveguide 644 by dry-etching. Moreover, the resist mask 646 may be used to fabricate a rib waveguide from the SiN waveguide 644.

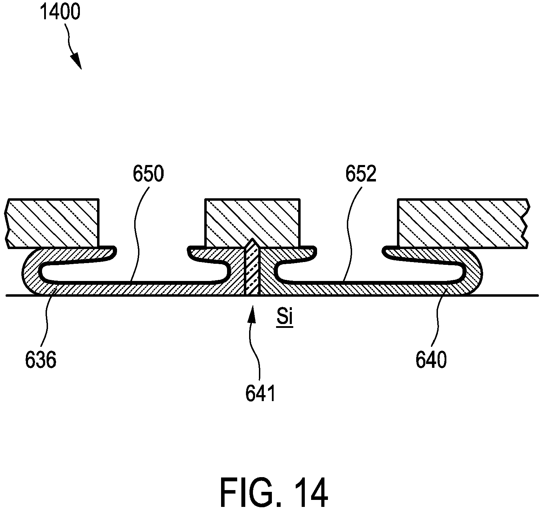

Figure 14 shows a ninth intermediate product 1400 that is obtained by further processing the eighth intermediate product 1300 described with reference to figure 13. The ninth intermediate product 1400 includes a first silicide layer 650 covering the p-doped contact region 636 and a second silicide layer 652 covering the n-doped contact region 640. In contrast to known device concepts, the laterally protruding p-doped edge portion 634 and the laterally protruding n-doped edge portion 638 are laterally deflected. Formed silicide, e.g., cobalt or nickel, is thus kept at a predefined distance from the optical field in the SiN waveguide 644. This can be beneficial for achieving opto-electrical -3 dB bandwidths far beyond 100 GHz, e.g., of 200 GHz or more.

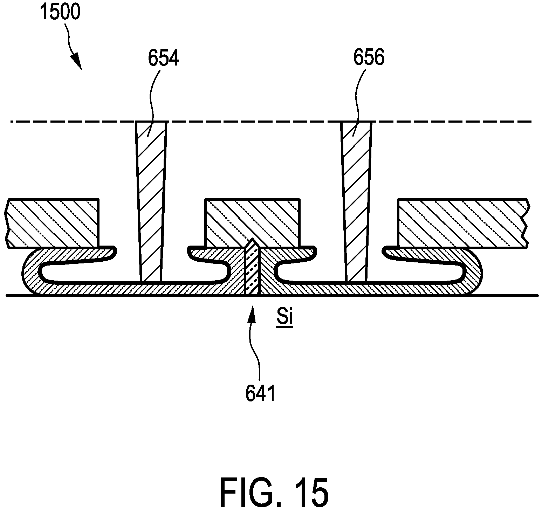

Figure 15 shows a tenth intermediate product 1500 that is obtained by further processing the ninth intermediate product 1400 described with reference to figure 14. The tenth intermediate product 1500 includes a first inter-layer dielectric (ILD0) stack and a back-end-of-line (BEOL) contact scheme including a first metal connector 654 for connecting the p-doped contact region 636 and a second metal connector 656 for connecting the n-doped contact region 640 of the photodiode 641.

Other variations to the disclosed embodiments can be understood and effected by those skilled in the art in practicing the claimed invention, from a study of the drawings, the disclosure, and the appended claims.

In the claims, the word "comprising" does not exclude other elements or steps, and the indefinite article "a" or "an" does not exclude a plurality.

The mere fact that certain measures are recited in mutually different dependent claims does not indicate that a combination of these measures cannot be used to advantage.

Any reference signs in the claims should not be construed as limiting the scope.

## Claims

1. A photodetector for detecting electromagnetic radiation, the photodetector comprising
- a lateral photodiode comprising an in-situ p-doped contact region, an in-situ n-doped contact region and, sandwiched between the p-doped contact region and n-doped contact region along a lateral stacking direction, an intrinsically doped light-sensitive region,
- a SiN waveguide comprising SiN and being configured to guide electromagnetic radiation along a propagation direction, the SiN waveguide being arranged on top of the lateral photodiode along a vertical stacking direction that is perpendicular to the lateral stacking direction, wherein
- at least a part of the light-sensitive region and at least a part of the SiN waveguide form a common upper interface at which the light-sensitive region is in direct contact with the SiN waveguide, and
- the light-sensitive region has a lateral width along the lateral stacking direction of 300 nm or less.

2. The photodetector of claim 1, wherein the p-doped contact region and the n-doped contact region comprise Si and the light-sensitive region comprises Ge.

3. The photodetector of at least one of the preceding claims, wherein the common upper interface between the light-sensitive region and the SiN waveguide is substantially planar or is concavely curved along the vertical stacking direction.

4. The photodetector of at least one of the preceding claims, wherein a lateral width of the SiN waveguide along the lateral stacking direction corresponds to the lateral width of the light-sensitive region or is larger than the lateral width of the light-sensitive region.

5. The photodetector of at least one of the preceding claims, wherein a lateral width of the SiN waveguide along the lateral stacking direction exceeds the lateral width of light sensitive region on both sides by at least 20 nm.

6. The photodetector of at least of the preceding claims, wherein
- the p-doped contact region comprises along the vertical stacking direction a p-doped connector region, a p-doped central region and a laterally protruding p-doped edge portion, wherein the laterally protruding p-doped edge portion has a larger lateral width along the lateral stacking direction than the p-doped central portion of the p-doped contact region, and/or
- the n-doped contact region comprises along the vertical stacking direction a n-doped connector region, a n-doped central region and a laterally protruding n-doped edge portion, wherein the laterally protruding n-doped edge portion has a larger lateral width along the lateral stacking direction than the n-doped central portion of the n-doped contact region.

7. The photodetector of claim 6, wherein a height of the laterally protruding p-doped edge portion and/or laterally protruding n-doped edge portion along the vertical stacking direction is equal to or smaller than a height of the light sensitive region along the vertical stacking direction.

8. The photodetector of at least of the preceding claims, comprising a Si waveguide that comprises Si and that is arranged below the photodiode along the stacking direction forming a common lower interface with the photodiode at which the Si waveguide is in direct contact with at least a part of the light sensitive region, wherein, preferably, the Si waveguide has a width along the lateral stacking direction that is equal to or larger than a lateral width of the photodiode.

9. The photodetector of at least of the preceding claims, wherein the light-sensitive region comprises an active material layer that is optically active and a capping layer for protecting the active material layer arranged on top of the active material layer along the vertical stacking direction, wherein the capping layer forms the common upper interface at which the light-sensitive region is in direct contact with the SiN waveguide.

10. A photonic integrated circuit or an electronic photonic circuit comprising the photodetector of at least one of the preceding claims.

11. A method for fabricating a photodetector, the method comprising the steps of
- fabricating a lateral photodiode comprising an in-situ p-doped contact region, an in-situ n-doped contact region and, sandwiched between the p-doped contact region and n-doped contact region along a lateral stacking direction, an intrinsically doped light-sensitive region, the light-sensitive region having a lateral width along the lateral stacking direction of 300 nm or less, and
- fabricating a SiN waveguide comprising SiN and being configured to guide electromagnetic radiation along a propagation direction, the SiN waveguide being arranged on top of the lateral photodiode along a vertical stacking direction that is perpendicular to the lateral stacking direction, such that at least a part of the light-sensitive region and at least a part of the SiN waveguide form a common upper interface at which the light-sensitive region is in direct contact with the SiN waveguide.

12. The method of claim 11, wherein fabricating the photodiode comprises
a) providing a photodetector intermediate product comprising an intrinsically-doped light-sensitive region having a lateral width of 300 nm or less that is embedded with its lateral sides into an insulating material layer that is arranged on a substrate, wherein with its top side facing away from the substrate along the vertical stacking direction, the light-sensitive region is in contact with a SiN hardmask covering the insulating material layer with the embedded light-sensitive region,
b) creating a first window in the SiN hardmask at a first predefined distance to a first one of the lateral sides of the light-sensitive region,
c) removing the insulating material layer exposed by the first window by underetching such that the first one of the lateral sides of the light-sensitive region is exposed and a first cavity is formed next to the insulating material layer,
d) epitaxially growing an in-situ p-doped layer covering at least parts of the SiN hardmask and the first one of the lateral sides of the light-sensitive region such that a laterally protruding p-doped edge portion is formed within the first cavity and in contact with the SiN hardmask and wherein in the laterally protruding p-doped edge portion, the p-doped contact region has a larger lateral width along the lateral stacking direction than a p-doped central portion of the in-situ p-doped layer,
e) filling the first cavity with an insulating material and exposing an upper surface of the SiN hardmask along the vertical stacking direction,
f) creating a second window at a second predefined distance to a second one of the lateral sides of the light-sensitive region such that the light-sensitive region is positioned between the first window and the second window, wherein by creating the first and second windows, the SiN waveguide is formed on top of the photodiode along the vertical stacking direction,
g) repeating steps c) to f) analogously for the second window, wherein instead of epitaxially growing an in-situ p-doped layer as per step d), an in-situ n-doped layer is epitaxially grown,
h) removing those parts of the in-situ p-doped layer and the in-situ n-doped layer that cover the lateral sides of the SiN waveguide, thereby forming the in-situ p-doped contact region and the in-situ n-doped contact region of the photodiode, respectively,
i) removing the insulating material within the first cavity and the second cavity to expose the in-situ p-doped contact region and the in-situ n-doped contact region of the photodiode, and
j) performing silicide formation of the in-situ p-doped contact region and the in-situ n-doped contact region.

13. The method of claim 11 or 12, wherein providing the photodetector intermediate product comprises
- before applying the SiN hardmask on top of the insulating material layer with the embedded light-sensitive region, chemically and/or mechanically polishing an outer surface of the insulating material layer with the embedded light-sensitive region along the vertical stacking direction to provide a smooth interface between the insulating material layer with the embedded light-sensitive region and the SiN hardmask.

14. The method of at least one of claims 11 to 13, wherein fabricating the SiN waveguide comprises
- exposing an outer surface of the SiN hardmask that faces along the vertical stacking direction, and
- patterning the SiN hardmask to define the shape of the SiN waveguide arranged on top of the photodiode.

15. Use of the photodetector of at least one of the claims 1 to 9 for detection of electromagnetic radiation in the wavelength range of 0.8 µm to 1.65 µm.
